# EUROPEAN PATENT APPLICATION

(11) **EP 4 527 513 A1**
(43) Date of publication of application: **26.03.2025**
(21) Application number: 24201468.6
(22) Date of filing: 19.09.2024
(51) Int. Cl.: B08B 13/00, G01N 21/94, G01N 21/95, H01L 21/56

(54) **DEVICE AND METHOD FOR DETECTING AND REMOVING CONTAMINANTS ON A MOULD FOR ENCAPSULATING ELECTRONIC COMPONENTS**

(30) Priority: 21.09.2023 NL 2035849
(71) Applicant: Besi Netherlands B.V., 6921 RW Duiven (NL)
(72) Inventor: VAN DRIEL, Albertus Franciscus Gerardus, 6915 XX Lobith (NL); FIERKENS, Henricus Antonius Maria, 6915 TR Lobith (NL)
(74) Representative: Patentwerk B.V.

(57) **Abstract**

The invention relates to a cleaning device (1) for detecting and removing contaminants (5) on a mould (2) for encapsulating electronic components, especially semiconductors, comprising: a light source (3) for irradiating a mould surface; an optical detector (7) for detecting irradiated contaminants on the mould surface; a moveable cleaner (9) for removing the contaminants; and a controller (10) for the cleaner. The invention also relates to a cleaning method for such a mould.

## Description

The present invention relates to a cleaning device as well as to a method for detecting and removing contaminants on a mould for encapsulating electronic components, especially semiconductors.

Electronic components are used on a huge scale and can for instance be formed by diodes (for example, light emitting diodes or LEDs), transistors, integrated circuits (IC/chips), chip-based sensors for detecting force, pressure, fingerprint, light and images, and chip-based actuators (MEMS; microelectromechanical systems) and/or other types of semiconductors. The electronic components may typically be mounted on a carrier, also referred to as a substrate. The carrier can be formed by, but not limited to, a wafer, a lead frame, or a (printed circuit) board.

When incorporating electronic components in electronic equipment it is often required to at least partially shield (encapsulate) the electronic component for which reason a housing may be moulded around the electronic component. The most common moulding techniques for encapsulating the above mentioned small electronic components are transfer and compression moulding. The electronic component may be fully embedded in such moulded housing but for the functionality of the electronic component the component may also be left at least party free of the housing to allow access to the electronic component e.g. for detection purposes and/or to cool the electronic component during use. Partly due to the increasing miniaturization the demands on the shape accuracy of the encapsulated electronic components are very high, and even more for the to the high demands on quality and accuracy of the encapsulated electronic components it is important that the encapsulation is realized with a high degree of accuracy.

For a good moulding result of fully or partially encapsulated electronic components like for instance semiconductors it is essential that the mould is substantially clean before the start of a moulding process. Well know is to clean a mould at the start of a moulding cycle when the mould parts are opened (placed at a mutual distance) and before the electronic components, often attached to a carrier, are placed in the mould. The cleaning may take place by full brushing, possibly in combination with the extraction of the loosened contaminants. After cleaning the mould parts are closed and the moulding process may start by bringing a liquid moulding material in mould openings.

The contaminants may have a random distribution over a mould surface and may consist of for instance residue's from a previous moulding action and/or airborne particles from the environment. The contaminants may typically particle shaped, sphere, shaped or blocky. The size of the contaminants may be - although not limited to - less than 250 µm, less than 100 µm or even smaller to a few microns. These contaminants may also have a tendency to stick to the mould surface due to adhesion (e.g. EMC epoxy), electrostatic charging, and/or gravity.

A problem of the prior art removal of contaminants on a mould for encapsulating electronic components is not a controlled process and/or that the removal of contaminants is often incomplete so that remaining contaminants may frustrate a high quality encapsulation of the electronic components.

Hence, the goal of the present invention is to overcome these disadvantages and to provide a device and method for detecting and removing contaminants on a mould for encapsulating electronic components which leads to a better and more controlled cleaning of such moulds.

To solve prior art problems the present invention provides a cleaning device for detecting and removing contaminants on a mould for encapsulating electronic components, especially semiconductors, comprising: at least one light source for irradiating a mould surface with at least one light beam; at least one optical detector for detecting the location of at least one irradiated contaminant on the mould surface; a relative moveable cleaner for removing contaminants from the mould surface; and a controller for driving the relative moveable cleaner to the detected location. Preferably the at least one light source is a laser. The cleaning device makes use of a light beam, which is here defined as a directional projection of light energy radiating from a light source, or - as an alternative definition - a line of electromagnetic radiation (of massless elementary particles called photons) substantially flowing in one direction. The light beam irradiating the mould surface will result in the scattering of light (thus also in directions different than that of the light beam) if the light beam is shining against a contaminant (particle) that is located on the mould surface. Such scattering of the light will be relatively easy to detect by the optical detector (e.g. a vision camera) so due to the use of the light beam in combination with the optical detector the sensitivity of the optical detector is enhanced. An advantage of the cleaning device according to the present invention is that also small contaminating particles that are normally invisible for the optical detector now become visible. The enhanced visual detection capability of contaminants enables to steer (control) the driven movement of the cleaner to those contaminated mould surface locations (e.g. detected X,Y-locations on the mould surface). After the relative moveable cleaner arriving at the contaminated locations the relative moveable cleaner may remove the contaminations. Due to the enhanced sensitivity of the visual detection the present cleaning device will be able to an improved cleaning of mould surfaces which will lead to an improved quality of the resulting encapsulated electronic components. And as only the contaminations have to be removed and not the complete surface has to be cleaned the cleaning is efficient (saves time) and thus also the chance new pollutions occur during the cleaning stage is limited. Furthermore the cleaner according to the present invention enables to verify the state of a mould surface to provide certainty of cleanliness.

With a "relative moveable cleaner" is specified that the cleaner may be movable and the mould surface may be stationary but also the cleaner may be stationary and the mould surface may be moveable, or alternatively both the cleaner and the mould surface may be moveable.

In an specific embodiment the at least one light source is a laser. A laser light source normally has a very high light emission and is normally also offered as a (laser) beam. Due to the high intensity as the scattering light effect of irradiated contaminations will have a relative high intensity and thus the detection of the locations where light scattering takes place will be easier to detect leading to a cleaning device with an enhance sensitivity. To enhance the sensitivity of the cleaning device according to the invention environmental light may - at least partially - be separated from the mould surface to be cleaned as environmental light may delimit the detection accuracy.

In a further embodiment the at least one light beam is a flat light beam. With a flat light beam reference is made to a beam with a cross-section having a width that is larger than its height. With such a flat light beam a wider part of the mould surface may be irradiated at once. A flat light beam thus may reduce the cycle time of the mould surface inspection. Also the irradiation of the mould surface may be a less critical subprocess. Additionally also a flat light beam with a substantial height (e.g. with a height of a few millimetres) may be advantageous as the light beam, that contacts the mould surface under an acute angle, will then light up a larger area of the mould surface. Such a light beam may be created by use of a laser diode with an adjustable focus.

The light beam may be stationary lighting the complete mould surface at once, but it also may be so that the light beam is moveable relative to the mould surface. The light beam irradiating of the complete mould surface may be a subprocess that is carried out sequentially, for instance in that the light beam strokes the surface of the mould surface. The complete surface may be irradiated with a single over the surface moving beam, but dependent on the size of the mould surface and the size of the light beam the light beam may also be moved over different strips of the mould surface multiple times.

The at least one light source may be positioned to irradiate the mould surface with a light beam at an acute angle, for instance an acute angle smaller than 30 degrees, preferably smaller than 20 degrees, more preferably smaller than 10 degrees, most preferably smaller than 5 degrees. The advantage of such lighting, also referred to a flood- or grazing lighting, is that the light scattering resulting from contact of the light beam with contaminations is well distinguishable from the light beam itself and thus relatively easy to detect.

The controller may comprise a memory to store the locations of the detected contaminants, which enables to uncouple the detection of contaminations from the removal of the detected contaminations. Subsequently the relative moveable cleaner may be relative moveable along the surface of the mould surface to be allocated such that detected contaminations may be removed from the mould surface. For such contamination removal the relative moveable cleaner may be provided with a blower head, a suction head, a brush head, a laser head and/or a scraping head. The automatic cleaning operation may be activated by means of a directed air flow ("air gun"), suction ("vacuum cleaner"), brushing, mechanical removal ("scraper"), and/or via laser cleaning. In a further embodiment the relative moveable cleaner may also be provided with a combination of at least a brush head, a laser head and/or a scraping head as well as a suction head enabling the brush head, laser head and/or scraping head to be moveable along the suction head. Such an embodiment enables to remove contaminations from the brush head, laser head and/or scraping head further away from the mould surface by suction. For an effective and efficient cleaning the relative moveable cleaner has a contact area with preferably a width of at least 5mm. A scraper of a scraper head also may possess a designed tilting play to create an accurate contact surface and an affective scraping edge.

The cleaner according to the invention may also be doubled embodied (with facing away light sources, optical detectors and relative moveable cleaners) for dual detection and removal, that means double detection and removal at the same time, of contaminants from the surfaces of opposite mould parts with facing surfaces. Such an embodiment enables the cleaning of the facing sides of opposing (opened) mould parts at the same time, thus limiting the cycle time.

The present invention also provides a cleaning method for detecting and removing contaminants on a mould for encapsulating electronic components, especially semiconductors, comprising the method steps: A) irradiating a mould surface of a mould for encapsulating electronic components with at least one light beam; B) detecting the locations of irradiated contaminants on the mould surface; and C) steering a relative moveable cleaner to remove the detected contaminants. With such a method the advantages as described above in relation to the cleaning device according to the present invention may also be realised, these advantages are here thus included by reference. The method may be relatively executed with a combination of off-the-shelf components and enables to enhance the quality of encapsulated electronic components which additionally provides clarity/certainty on the cleaning state of a mould surface cleaned with the method according to the present invention.

As explained above the mould surface may preferably be irradiated with a laser beam as such light source has a high intensity and is capable to be directed in a beam, more preferably a flat beam. The light beam may moveable irradiate the mould surface to enable lighting of the complete surface of a mould to be cleaned and for an improved visibility of the contaminations the light beam may irradiate the mould surface at an acute angle, for instance an angle that is smaller than 30 degrees, preferably smaller than 20 degrees, more preferably smaller than 10 degrees, most preferably smaller than 5 degrees. An advantage of such acute angled lighting the mould surface is that roughness and scratches of the mould surface are less visible than with frontal lighting. Subsequently the locations of the detected contaminants may be stored, which facilitates to move the cleaner relative to the surface of the mould surface to the locations of the detected contaminants.

As to further enhance the cleaning capabilities of the method according to the present invention the detecting the area where contaminations may be located a dual detection method may be used. In a first detection step an (not yet irradiated) area with potential contaminations may be detected after which first detection step a second detection step may be executed wherein the area with potential contaminations is irradiated. This enable to delete the background information (detected during the first detection step) from the information gathered during the second detection step leading towards a higher detection level en thus an enhanced cleaning result.

The relative moveable cleaner, being located there where contaminations are detected, may remove these contaminants by suction, blowing, brushing and/or mechanical engagement. Furthermore not only the locations of the detected contaminations may be stored but also the locations of clean areas, scratched areas, operated accepted irregularities, or area with exclusions for cleaning (e.g. areas with mould vacuum holes) to prevent "false" detections. The contaminations may be moved in an outward direction of the mould surface to be cleaned and if they are not directed moved away from the mould area to be cleaned they may be moved away in two or more subsequent steps.

The method according to the invention may be performed by using a cleaning device according to the present invention.

The invention will be further elucidated on the basis of the non-limitative exemplary embodiments shown in the following figures. Corresponding elements are designated in the figures with corresponding reference numerals. Herein shows:
figure 1 a schematic view on a first part of the cleaning device according to the present invention;
figure 2 a schematic view on a second part of the he cleaning device according to the present invention, together with the first part as shown in figure 1 making the complete cleaning device according to the present invention;
figure 3 a cross-sectional side-view on an optional scraper head part of the cleaning device according to the present invention;
figure 4 a schematic view on a scraper during a cleaning operation; and
figure 5 a schematic overview of the process steps of the cleaning method for detecting and removing contaminants according to the present invention.

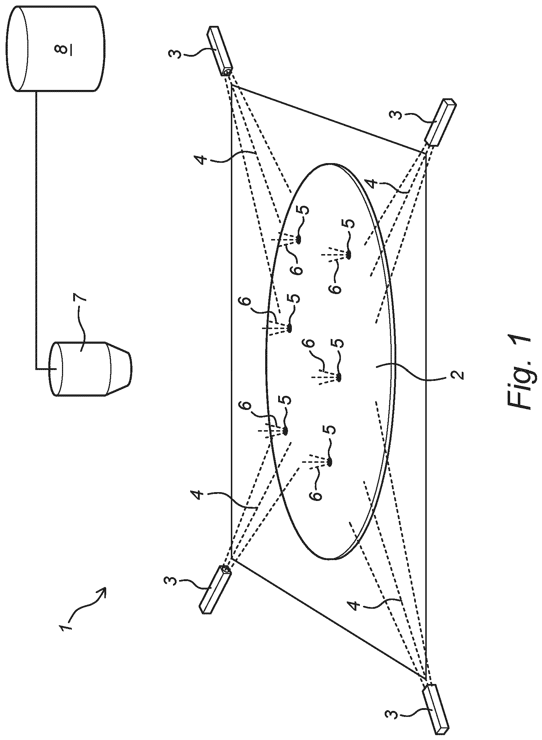

Figure 1 shows a schematic view on a first part of the cleaning device 1 according to the present invention wherein a mould surface 2 is irradiated by four light sources 3, here laser lights. Due to the laser rays of light 4 shining against contaminations 5 sidewards (seen from the surface of the mould surface 2) laser light is deflected which deflected light 6 enables a camera 7 relatively simple to detect the contaminations 5 on the mould surface 2 (when compared to a situation without the use of the sideward lighting of the contaminations 5). After detections of the locations (e.g. X, Y coordinates) of the contaminations 5 on the mould surface 2 these locations (X₁, Y₁ ; X₂, Y₂, ....) are stored in a database 8.

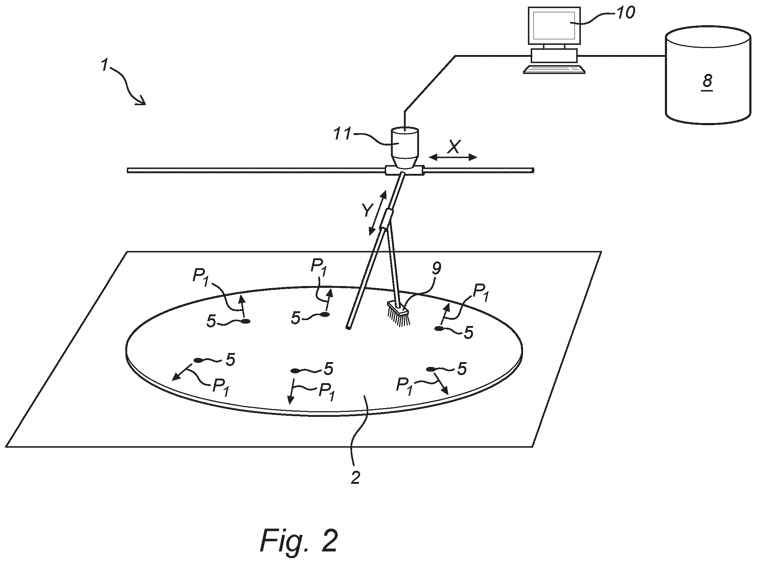

Figure 2 shows the second part of the he cleaning device 1 according to the present invention, together with the first part as shown in figure 1 making the complete cleaning device 1. Herein the mould surface 2 with the allocated contaminations 5 is cleaned by a cleaner 9 that is relative moveable to the mould surface 2. A computer 10 is fed with the allocations of the detected contaminations 5 from the database 8. The computer (controller) 10 steers a controller 11 making the cleaner to be moved in X, Y directions (see arrows) relative to the mould surface 2. In this figure 2 the mould surface is stationary but as an alternative the mould surface may also controllable moved by the computer 10. With the cleaner (here a brush or broom) the contaminations 5 may be moved outwards (see arrows P₁) away from the operative part of the mould surface 2.

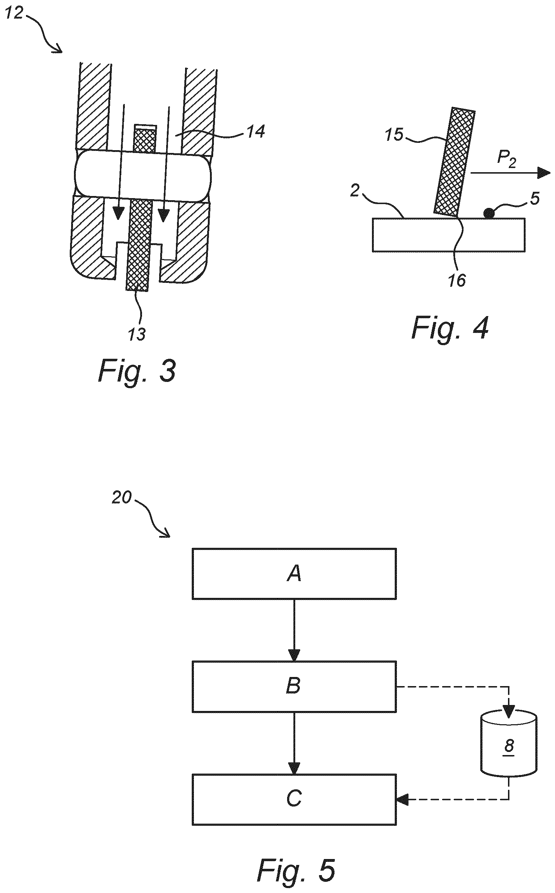

Figure 3 shows a a cross-sectional side-view on a cleaner embodied as a scraper head 12. Here a central scraping element 13 is surround by an air passage 14 through which an air flow can be supplied. Such a scraper head 12 combines two cleaning techniques; scraping and blowing.

In figure 4 a schematic a scraper 15 is shown during a cleaning operation wherein a contamination 5 on mould surface 2 is slided away (see arrow P₂) with a skew scraper 15 providing a sharp contact edge 16.

Figure 5 is showing a schematic overview 20 of the process steps of the cleaning method for detecting and removing contaminants 5 on a mould surface 2 according to the present invention. In a process step A a mould surface 2 of a mould for encapsulating electronic components is irradiated with at least one light beam. In a subsequent process step B the locations of irradiated contaminants on the mould surface is detected and the locations of the contaminations are stored in a database 8. In the next process step C the relative moveable cleaner is steered based on location information retrieved from the database 8 to remove the detected contaminants 5 from the mould surface 2. Additionally to the here described process also an initial detection of the mould surface may be included to enable the deletion of background information from the information gathered during the second (irradiated) detection step.

## Claims

1. Cleaning device for detecting and removing contaminants on a mould for encapsulating electronic components, especially semiconductors, comprising:
- at least one light source for irradiating a mould surface with at least one light beam;
- at least one optical detector for detecting the location of at least one irradiated contaminant on the mould surface;
- a relative moveable cleaner for removing contaminants from the mould surface; and
- a controller for driving the relative moveable cleaner to the detected location.

2. Cleaning device according to claim 1, **characterised in that** the at least one light source is a laser.

3. Cleaning device according to claim 1 or 2, **characterised in that** the at least one light beam is a flat light beam.

4. Cleaning device according to any of the preceding claims, **characterised in that** the light beam strokes the surface of the mould surface.

5. Cleaning device according to any of the preceding claims, **characterised in that** the light beam is a relative moveable light beam.

6. Cleaning device according to any of the preceding claims, **characterised in that** the at least one light source is positioned to irradiate the mould surface with a light beam at an acute angle.

7. Cleaning device according to claim 6, **characterised in that** the acute angle is smaller than 30 degrees, preferably smaller than 20 degrees, more preferably smaller than 10 degrees, most preferably smaller than 5 degrees.

8. Cleaning device according to any of the preceding claims, **characterised in that** the controller comprises a memory to store the locations of the detected contaminants.

9. Cleaning device according to any of the preceding claims, **characterised in that** the relative moveable cleaner is moveable along the surface of the mould surface.

10. Cleaning method for detecting and removing contaminants on a mould for encapsulating electronic components, especially semiconductors, comprising the method steps:
A) irradiating a mould surface of a mould for encapsulating electronic components with at least one light beam;
B) detecting the locations of irradiated contaminants on the mould surface; and
C) steering a relative moveable cleaner to remove the detected contaminants.

11. Cleaning method according to claim 10, **characterised in that** the mould surface is irradiated with a laser beam.

12. Cleaning method according to claim 10 or 11, **characterised in that** the light beam moveable irradiates the mould surface.

13. Cleaning method according to any of the claims 10- 12, **characterised in that** the light beam irradiates the mould surface at an acute angle.

14. Cleaning method according to claim 13, **characterised in that** the acute angle is smaller than 30 degrees, preferably smaller than 20 degrees, more preferably smaller than 10 degrees, most preferably smaller than 5 degrees.

15. Cleaning method according to any of the claims 10- 14, **characterised in that** the locations of the detected contaminants are stored.

16. Cleaning method according to any of the claims 10- 15, **characterised in that** the relative moveable cleaner is moved along the surface of the mould surface to the locations of the detected contaminants.

17. Cleaning method according to any of the claims 10 - 16, **characterised in that** in performing the method use is made of a cleaning device according to any of the claims 1 - 9.
